# FASCICULE DE BREVET EUROPEEN

(11) **EP 2 166 363 B1**
(45) Date de publication et mention de la délivrance du brevet: **17.08.2016**
(21) Numéro de dépôt: 08305580.6
(22) Date de dépôt: 22.09.2008
(51) Int. Cl.: G01R 31/02, G01R 19/145

(54) **Dispositif de connexion multistandard**
Multistandard-Anschlussvorrichtung
Multi-standard connection device

(43) Date de publication de la demande: 24.03.2010
(73) Titulaire: Hager Controls SAS, 67703 Saverne (FR)
(72) Inventeur: Paillard, Jean-Noël, 67700 Saverne (FR)
(74) Mandataire: Nuss, Laurent

(56) Documents cités:
- EP-A- 1 641 178
- US-A- 3 549 995
- US-A- 5 617 018

## Description

La présente invention a trait à un dispositif de connexion multistandard permettant la détection de la nature et de l'état d' « entrées », c'est-à-dire typiquement de paires de fils électriques susceptibles de véhiculer des signaux, afin qu'un système ou un actionneur en aval puissent agir en fonction dudit état. Un tel dispositif peut notamment s'avérer très utile dans le cadre d'applications domotiques ou électroniques domestiques, dans lesquelles plusieurs types d'entrées sont couramment utilisés, qu'il est par conséquent souhaitable de grouper en un unique système rendu automatiquement accessible aux différents types de connexions. L'invention concerne aussi un procédé de détection de la nature et de l'état des entrées d'un tel dispositif de connexion.

Le dispositif de l'invention s'applique par exemple aux entrées secteur traditionnelles, pour détecter la présence ou non d'une tension alternative aux bornes du dispositif. L'intervalle des tensions détectables est d'ailleurs étendu, dans le cadre du dispositif de l'invention, de manière à fonctionner entre une valeur basse de l'ordre de 12 volts et une valeur haute de l'ordre de 250 volts. L'objectif du dispositif est alors de détecter, après reconnaissance de la nature de l'entrée - en l'espèce deux fils véhiculant une tension alternative -, si un organe de commande de type bouton-poussoir est actionné ou non.

Le même objectif est assigné à l'invention dans l'hypothèse où la tension alternative est véhiculée par un circuit à bouton-poussoir équipé de voyant(s), voire dans l'hypothèse où cet ensemble est remplacé par un triac. Les conditions de fonctionnement deviennent alors très différentes de la première hypothèse, puisqu'il n'existe plus d'état à tension coupée.

Le dispositif de l'invention doit également fonctionner en courant continu, dans une plage large incluant de la basse tension d'environ 12 volts jusqu'à une tension haute de l'ordre de 250 volts. La problématique est alors la même qu'en régime alternatif, à savoir détecter l'activation d'un organe de commande de type bouton-poussoir ou contact.

Enfin, le système de l'invention doit pouvoir être utilisé avec des contacts secs, c'est-à-dire sans source extérieure de tension ou de courant, ou encore pour du comptage dans toutes les hypothèses précitées, l'entrée servant dans ce cas à compter le nombre de commutations d'un contact situé en amont.

Le document US 5617018 décrit un dispositif pour mesurer une vaste gamme de tensions et de détermination de la continuité.

Pour des questions de respect des standards ou des normes règlementant la protection des personnes en ce qui concerne les risques électriques, il est prévu que les entrées traitées par le dispositif multistandard de l'invention soit isolées du reste de l'électronique dudit dispositif.

Pour répondre à la double problématique de la multiplicité de la nature des entrées à détecter d'une part, et de la nécessité de l'isolation de chaque entrée par rapport au reste du circuit électronique d'autre part, le dispositif de connexion multistandard de l'invention tel que défini à la revendication 1, permettant comme mentionné auparavant la détection de la nature et de l'état de multiples types d'entrées à deux fils dotées de commutateurs de commande, se caractérise à titre principal en ce qu'il consiste en un circuit électronique comportant un étage de connexion des deux fils, le courant en entrée étant traité successivement par un étage d'adaptation limitant ledit courant dans une plage prédéterminée et par une interface de lecture le transformant en un signal intelligible envoyé à une unité de traitement détectant la nature et l'état de l'entrée, ladite unité envoyant des signaux de sortie vers un étage de polarisation du contact sec et vers un commutateur d'application de la polarisation de voyants lumineux, ces étages étant reliés à un étage assurant ladite polarisation, dont la sortie est connectée à l'étage de connexion, des moyens d'isolation étant prévus entre l'étage de connexion et l'unité de traitement.

Un circuit électronique particulier a donc été conçu pour faire face aux différents types d'entrées appliquées au dispositif de l'invention de manière totalement transparente à l'utilisateur, qui n'a aucune manipulation particulière à effectuer à part le branchement des fils sur une entrée du dispositif, au niveau de l'étage de connexion. La détection de la nature et de l'état de l'entrée est ensuite faite automatiquement par le circuit constituant le dispositif de l'invention.

Une telle solution se démarque des configurations actuellement disponibles, qui nécessitent dans la plupart des cas l'emploi de plusieurs produits de connexion différents dans le cas où l'utilisateur utilise des systèmes dont les entrées sont différentes. Dans le meilleur des cas, les constructeurs ont prévu des possibilités de regroupements des entrées, cependant limités à quelques configurations.

Or, la gestion simultanée ou séquentielle de plusieurs types d'entrées est une hypothèse concrète qui se pose dans nombres d'environnements actuels. A titre d'exemple, les lectures d'une entrée d'automate, d'un interrupteur classique câblé en 230 volts, avec ou sans voyant lumineux, ou encore d'un contact sec de sortie d'un capteur s'effectuent de manière très différente, et les produits classiques de l'art antérieur sont incapables de traiter toutes ces hypothèses sur un même plan. Au mieux, il existe une combinaison de produits permettant la lecture d'entrées de type contact sec ou véhiculant une tension alternative ou continue, sur une plage allant d'environ 12 volts à 230 volts, mais sans prise en compte de voyants lumineux. Le problème est donc incomplètement résolu à ce jour.

Le circuit de l'invention, qui libère l'utilisateur de la problématique liée au choix d'un dispositif de connexion adapté, permet de plus d'éviter de se soucier du sens de câblage dans l'hypothèse d'une tension continue.

Enfin, le recours à une entrée isolée permet de s'affranchir d'une alimentation spécifique notamment dans le cas du contact sec, le courant nécessaire à la détection étant fourni directement par le circuit de l'invention. Selon l'invention, les moyens d'isolation formant en fait la barrière d'isolation sont organisés simultanément au niveau de l'interface de lecture, du commutateur d'application de la polarisation et de l'étage de polarisation du contact sec.

La mise en oeuvre de cette barrière sera expliquée plus en détail dans la suite. Par ailleurs, le circuit de l'invention est symétrique, de sorte que les entrées peuvent être branchées de manière dépolarisée.

Selon une possibilité, un premier étage de protection contre les chocs électriques et les défauts de court-circuit est disposé immédiatement en aval de l'étage de connexion. Plus précisément, il est de préférence constitué d'une simple résistance placée après une borne de connexion.

Cet étage a pour fonction de protéger l'ensemble contre les éventuelles ondes de chocs venues de l'extérieur, ainsi que contre les risques résultant de mauvais câblages toujours possibles. Il permet en outre d'éviter que le produit ne soit dangereux en cas de défaillance de composants, en offrant une limitation de courant.

L'étage d'adaptation limitant la plage de courants à destination de l'interface de lecture est par exemple constitué de deux résistances connectées en série, découplées par une capacité raccordée en parallèle aux résistances, ladite capacité servant de plus à la polarisation des voyants lumineux, comme cela sera montré dans la suite.

Il permet de garantir que le courant qui traverse ensuite l'interface de lecture est contenu dans un intervalle de valeurs acceptables pour cette dernière, dans le but de garantir une bonne détection de l'état de l'entrée.

Cette interface de lecture peut par exemple être basée sur un optocoupleur en sortie duquel est connecté un transistor, la sortie du transistor étant protégée par une capacité disposée entre l'émetteur et la base.

Elle a pour but de transformer des signaux présents sur les fils de l'étage de connexion en signaux compréhensibles par l'unité de traitement. Il s'agit plus précisément d'une adaptation du niveau desdits signaux par rapport à l'unité de traitement, incluant une fonction d'isolation réalisée par le couplage optique.

Pour assurer la dépolarisation du circuit, l'optocoupleur est prévu bidirectionnel. De manière classique, l'émetteur et la base du transistor disposés en sortie de l'optocoupleur sont polarisés par des résistances connectées entre l'alimentation et lesdites électrodes.

L'unité de traitement permet la lecture et l'interprétation des signaux issus de l'étage de lecture, et elle effectue le traitement nécessaire à la détection du type d'entrée et de l'état de chacune d'entre elles.

Elle envoie des signaux en sortie notamment vers l'étage de polarisation du contact sec, lequel est basé sur un transformateur dont un premier enroulement est relié à l'unité de traitement et le second enroulement est raccordé à l'étage de connexion via l'étage de polarisation des voyants. De manière classique, le premier enroulement est relié à l'unité de traitement via une diode de protection et une résistance, le second enroulement étant raccordé à une résistance connectée en série à une capacité, laquelle est reliée à la capacité de polarisation des voyants lumineux.

Le but est de fournir un courant d'environ 2 milliampères suffisant pour la polarisation des contacts secs éventuellement connectés. Cette alimentation est de plus réalisée de façon isolée grâce au transformateur qui fait partie des moyens d'isolation mentionnés auparavant.

Le commutateur d'application de la polarisation des voyants lumineux est, dans l'invention, basé sur un relais statique bidirectionnel à commande opto-électronique dont l'entrée est polarisée par une résistance et la sortie reliée à des diodes de régulation de tension connectées inversées en série. L'utilisation d'une solution opto-électronique permet là encore d'assurer l'isolation entre l'unité de traitement et les entrées. Des moyens d'isolation tels que mentionnés auparavant sont donc établis à tous les niveaux de liaison possibles entre l'unité de traitement et les entrées du circuit.

L'objectif est d'activer/désactiver la polarisation des voyants lumineux à l'aide d'une capacité dont la faible impédance permet de fournir un courant suffisant à la polarisation des voyants lumineux ou à un triac sensible selon le cas.

Comme indiqué auparavant, l'invention s'applique aussi à un procédé tel que défini à la revendication 13.

L'invention va à présent être décrite plus en détail, en référence aux figures annexées, pour lesquelles :
- la figure 1 représente différentes configurations d'entrée traitées par le dispositif de connexion multistandard de l'invention ;
- la figure 2 montre un schéma synoptique du circuit électronique du dispositif de l'invention ; et
- la figure 3 représente un circuit électronique correspondant à une possibilité de dispositif de connexion multistandard selon l'invention.

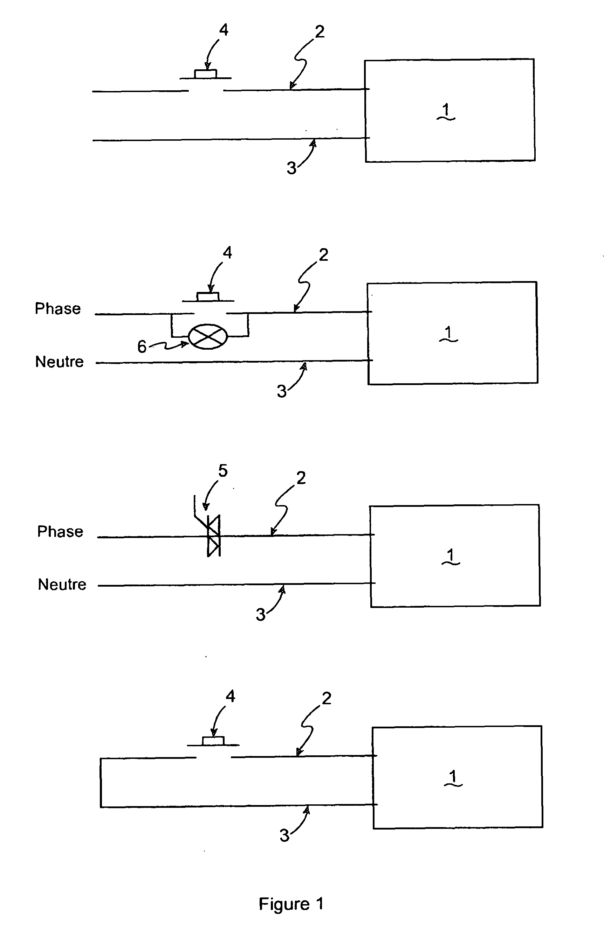

En référence à la figure 1, quatre entrées possibles traitées par le dispositif de l'invention sont montrées.

Dans les quatre cas, l'entrée est représentée par un bloc (1) avec deux fils de connexion (2, 3). Dans trois cas sur quatre, l'organe de commande est constitué d'un bouton-poussoir ou équivalent (4) alors que, dans l'une des configurations, il s'agit d'un triac (5). Un voyant lumineux (6) peut être associé à l'organe de commande (4), comme cela apparaît sur le second schéma. Le premier schéma s'applique aussi bien à une entrée secteur traditionnelle qu'à une entrée à courant continu. Dans les deux cas, la plage de tension qui est gérée peut aller d'environ 12 volts à 250 volts.

Le quatrième schéma concerne une entrée dite à contact sec, dans laquelle aucune tension ou courant extérieur ne sont présents, l'énergie étant fournie par le circuit en aval.

Le dispositif de l'invention est également apte à compter un certain nombre de commutations d'un contact (4), dans l'une ou l'autre des configurations de la figure 1.

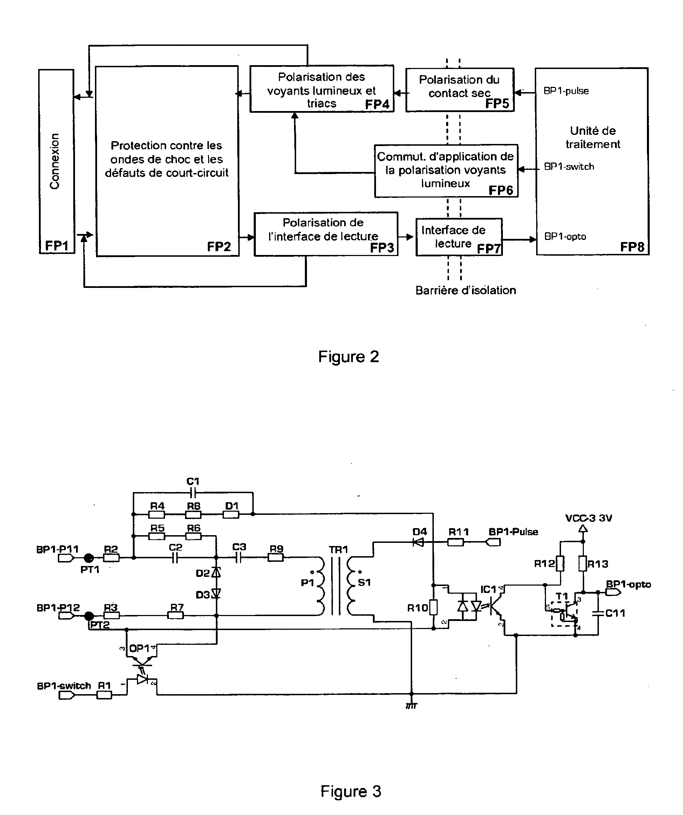

Pour répondre au problème mentionné à titre principal, c'est-à-dire détecter la nature des entrées présentées en figure 1 et lire de manière transparente pour l'utilisateur leurs états, le dispositif de l'invention présente une architecture telle qu'apparaissant sous forme d'organigramme en figure 2. Ainsi, un premier étage de connexion (FP1) permet le raccordement des fils en entrée.

Un étage de protection (FP2) contre les ondes de choc et les défauts de court-circuit est placé directement en aval de l'étage de connexion (FP1). Le signal est ensuite envoyé à un étage d'adaptation (FP3) maintenant le courant dans une plage prédéterminée, cet étage (FP3) réalisant de fait la polarisation d'une interface de lecture (FP7) vers lequel le signal est ensuite envoyé. Cette interface (FP7) transforme le courant en un signal intelligible à une unité de traitement (FP8) placée en sortie de cet étage (FP7) et qui détecte la nature et l'état de l'entrée. Cette unité se charge en réalité d'interpréter les signaux issus de l'interface de lecture (FP7). Elle effectue le traitement nécessaire à la détection du type et de l'état de l'entrée, comme on le verra plus en détails dans la suite.

L'unité de traitement (FP8) émet ainsi des signaux, d'une part à destination d'un commutateur d'application de la polarisation des voyants lumineux (FP6), qui active/désactive un étage de polarisation (FP4) des voyants ou triacs éventuellement présents. Le signal est ensuite renvoyé vers la sortie, c'est-à-dire vers l'étage de connexion (FP1). L'unité de traitement (FP8) envoie également un signal à destination d'un étage de polarisation du contact sec (FP5) fournissant un courant suffisant pour la détection d'un tel contact. L'alimentation en courant se fait dans ce cas de manière électriquement isolée, de même que l'interface de lecture (FP7) est conçue pour isoler l'unité de traitement de l'entrée du dispositif. Il en va de même pour le commutateur (FP6) d'application de la polarisation du voyant lumineux et des triacs, qui est conçu pour organiser une isolation entre l'unité de traitement (FP8) et l'étage de polarisation (FP4) proprement dit, comme cela deviendra apparent dans l'exemple de réalisation montré en figure 3.

Le fonctionnement du circuit apparaissant dans cette figure 3 est le suivant :
Dans l'hypothèse de la lecture d'une tension alternative pouvant aller de 12V à environ 250V, et en l'absence de voyant lumineux, si le contact ou commutateur en amont est fermé, la tension alternative est directement présente aux bornes d'entrées BP1-P11 et BP1-P12, La chute de tension étant négligeable dans R2, un courant suffisant traverse la branche de l'optocoupleur IC1 principalement via R4, R8 et D1 mais également par C1 (cette dernière présentant une impédance toutefois relativement élevée à la fréquence de 50 Hz). Le transistor T1 en sortie de cet optocoupleur IC1 devient alors passant, et la tension en entrée de l'unité de traitement passe de 0 à 1. La sortie du transistor T1 est protégée par une capacité C11, et il est classiquement polarisé par des résistances R12, R13.

Comme IC1 est un optocoupleur bidirectionnel, à chaque fois que l'amplitude de la tension alternative passe au voisinage de 0, et du fait que la tension de seuil de la diode de l'optocoupleur est d'environ 1V aux bornes de la diode, soit 7V environ sur l'amplitude de la tension d'entrée, le transistor bascule. Un signal carré de fréquence 100 Hz est alors présent en entrée (BP1-opto) de l'unité de traitement (non représentée en figure 3) : cette dernière en déduit qu'il s'agit soit d'une tension alternative et d'un contact fermé, soit d'une entrée alternative avec voyant et contact ouvert. A ce stade, les deux hypothèses sont encore possibles.

L'unité de traitement (FP8) envoie alors un stimulus d'ouverture (via la sortie BP1-switch) au commutateur de polarisation des voyants lumineux (FP6) durant un court instant : il s'agit du commutateur OP1 de la figure 3, en l'occurrence un relais statique bidirectionnel à commande opto-électronique, qui se ferme et peut par conséquent être traversé par un courant. Ce composant est polarisé par une résistance R1 en entrée, et sa sortie est reliée à des diodes D2, D3 connectées en série et inversées.

Lorsque l'entrée consiste simplement en deux conducteurs véhiculant une alimentation alternative sans qu'il y ait nécessité d'une phase polarisant des voyants, la tension sur l'interface de connexion ne subit aucune discontinuité. Le signal en entrée de l'unité de traitement non plus, et celle-ci en déduit par conséquent qu'il s'agit de la première option, à savoir une tension alternative et un contact sans voyant fermé.

Elle répète ce test à chaque alternance afin de vérifier que le type d'entrée n'a pas changé.

Si le contact en amont est ouvert, aucun courant ne parcourt l'optocoupleur IC1, qui reste par conséquent à l'état de repos : l'unité de traitement (FP8) reçoit à son entrée BP1-opto un signal à l'état bas permanent. Durant cette phase, elle lance une phase de détection et envoie à cet effet, via sa sortie BP1-pulse, la diode D4 et la résistance R11, un courant haute fréquence (qui peut ainsi traverser plus facilement C2 et C1) dans le transformateur TR1. Un courant est alors présent de l'autre coté de ce dernier, qui traverse principalement R9, C1, C2, C3 et IC1.

L'optocoupleur IC1 est alors polarisé et peut renvoyer, en écho, le signal haute fréquence à l'identique sur l'entrée BP1-opto de l'unité de traitement (FP8) qui en déduit que l'entrée est "ouverte" par lecture de ladite fréquence identique.

Dans l'hypothèse de la lecture d'une tension alternative avec voyants (6) câblés en parallèle au commutateur (4) apparaissant en figure 1, et lorsque ce dernier est fermé, la situation est identique à ce qui a été expliqué en référence au contact fermé pour une entrée de tension alternative sans voyants (6). Lorsque le contact est ouvert, une tension est présente sur l'interface de lecture (FP7). Un signal 100 Hz est donc également présent sur l'entrée BP1-opto de l'unité de traitement (FP8) qui détecte cette fréquence et en déduit qu'il s'agit soit d'une tension AC et d'un contact fermé (voir ci-dessus), soit d'une entrée AC avec voyant et d'un contact ouvert.

Elle lance alors via BP1-switch le stimulus d'ouverture du commutateur de polarisation des voyants lumineux (FP6) durant un court instant, entraînant la fermeture du relais statique bidirectionnel à commande opto-électronique OP1 et provoquant une chute de tension brutale aux bornes de l'interface de lecture (FP7), principalement due au fait que la capacité C2 se charge à travers la résistance série du ou des voyants. Grâce à la faible impédance de la capacité C2, un courant suffisant (de l'ordre de 10 mA) est fourni aux voyants lumineux ou au triac.

Une discontinuité intervient dans ce cas sur le signal 100 Hz présent sur l'entrée BP1-opto de l'unité de traitement (FP8), l'optocoupleur IC1 étant dépolarisé un court instant.

L'unité de traitement (FP8) détecte cette discontinuité et en déduit qu'il s'agit d'une entrée à voyant et que le contact est ouvert. Ce test est répété à chaque alternance afin de vérifier que le type d'entrée n'a pas changé.

Dans le cas de la lecture d'une tension DC de 12V à 253V, si le contact est fermé, une tension DC est présente sur l'entrée de l'interface de lecture (FP7). La chute de tension est négligeable dans R2. Un courant suffisant traverse alors la diode de l'optocoupleur IC1 principalement via R4, R8 et D1 (pas par C1, qui est d'une impédance infinie vis-à-vis d'une tension continue). Le transistor de cet optocoupleur IC1 devient alors passant, et la tension en entrée BP1-opto de l'unité de traitement (FP8) passe de 0 à 1. Comme IC1 est un optocoupleur bidirectionnel, le sens de la tension DC n'est pas important, et le câblage peut donc se faire indifféremment dans un sens ou dans l'autre. Le signal présent en entrée de l'unité de traitement (FP8) est donc continu et à l'état haut. Cette dernière en déduit qu'il s'agit d'une tension DC et que le contact est fermé.

Dans l'hypothèse d'un contact ouvert, la situation est la même que lorsque le contact est ouvert pour une entrée de tension AC de 12V à 253V alternative classique (cf. ci-dessus).

Si l'entrée est du type contact sec avec contact fermé, aucune tension n'est présente non plus sur l'entrée de l'interface de lecture (FP7). Aucun courant ne parcourt dès lors l'optocoupleur IC1, qui reste par conséquent à l'état de repos. L'unité de traitement (FP8) voit en BP1-opto un signal à l'état bas permanent. Durant cette phase, elle lance par conséquent la même phase de détection qu'auparavant, en envoyant via BP1-pulse, la diode D4 et la résistance R11 un courant haute fréquence (qui peut ainsi traverser plus facilement C2 et C1) dans le transformateur TR1.

Le courant généré dans le secondaire de ce dernier traverse principalement R9, C2, C3, R2 et le contact sec fermé, mais plus C1 ni la branche de l'optocoupleur IC1. Aucune tension n'est présente sur l'optocoupleur IC1, le courant étant dévié par le contact fermé. L'optocoupleur IC1 n'est par conséquent pas polarisé et ne renvoie pas le signal haute fréquence sur l'entrée de l'unité de traitement, qui en déduit que l'entrée est "fermée".

Dans l'hypothèse du contact sec ouvert, la situation est identique à celle du contact ouvert pour une entrée de tension de 12V à 253V alternative ou continue classique telle que décrite ci-dessus.

Enfin, pour une entrée de type comptage, le principe utilisé pour lire des impulsions est le même que celui présenté plus haut. Un traitement rapide permet simplement de pouvoir lire à une fréquence élevée (maximum 20 Hertz) les différents changements d'état et ainsi de couvrir les applications de comptage.

## Revendications

1. Dispositif de connexion multistandard permettant la détection de la nature et de l'état d'entrées à deux fils (2, 3) comportant un triac (5) à courant de maintien inférieur à 10 mA ou au moins un commutateur (4) de commande, lesdites entrées étant du type :
- issues d'un contact sec ;
- véhiculant une tension alternative comprise entre 12V et 250V ;
- véhiculant une tension continue comprise entre 12V et 250V ; ou
- véhiculant une tension alternative comprise entre 195V et 250V avec au moins un voyant lumineux (6) associé au(x) commutateur(s) (4) ou au triac (5),
le dispositif de connexion
consistant en un circuit électronique comportant un étage de connexion (FP1) des deux fils (2, 3), **caractérisé en ce que** le courant en entrée est traité successivement par un étage d'adaptation (FP3) limitant ledit courant dans une plage prédéterminée et par une interface de lecture (FP7) le transformant en un signal intelligible envoyé à une unité de traitement (FP8) détectant la nature et l'état de l'entrée, ladite unité (FP8) envoyant des signaux de sortie vers un étage de polarisation du contact sec (FP5) et vers un commutateur d'application de la polarisation de voyants lumineux (FP6), ces étages étant reliés à un étage (FP4) assurant ladite polarisation, dont la sortie est connectée à l'étage de connexion (FP1), des moyens d'isolation étant prévus entre l'étage de connexion (FP1) et l'unité de traitement (FP8).

2. Dispositif de connexion multistandard selon la revendication précédente, **caractérisé en ce que** les moyens d'isolation sont organisés simultanément au niveau de l'interface de lecture (FP7), du commutateur d'application de la polarisation de voyants lumineux (FP6) et de l'étage de polarisation du contact sec (FP5).

3. Dispositif de connexion multistandard selon l'une des revendications précédentes, **caractérisé en ce que** le circuit est symétrique, de sorte que les entrées (2, 3) peuvent être branchées de manière dépolarisée.

4. Dispositif de connexion multistandard selon l'une des revendications précédentes, **caractérisé en ce qu'**un premier étage de protection (FP2) contre les chocs électriques et les défauts de court-circuit est disposé immédiatement en aval de l'étage de connexion (FP1).

5. Dispositif de connexion multistandard selon la revendication précédente, **caractérisé en ce que** l'étage de protection (FP2) est constitué d'une résistance R2 placée après une borne de connexion.

6. Dispositif de connexion multistandard selon l'une quelconque des revendications précédentes, **caractérisé en ce que** l'étage d'adaptation (FP3) limitant la plage des courants destinés à l'interface de lecture (FP7) est constitué de deux résistances R5, R6 connectées en série, découplées par une capacité C2 raccordée en parallèle aux résistances R5, R6, ladite capacité C2 servant de plus à la polarisation des voyants lumineux (6).

7. Dispositif de connexion multistandard selon l'une quelconque des revendications précédentes, **caractérisé en ce que** l'interface de lecture (FP7) est basée sur un optocoupleur IC1 en sortie duquel est connecté un transistor T1, la sortie du transistor T1 étant protégée par une capacité C11 disposée entre l'émetteur et le collecteur.

8. Dispositif de connexion multistandard selon l'une des revendications précédentes, **caractérisé en ce que** l'optocoupleur IC1 est bidirectionnel.

9. Dispositif de connexion multistandard selon la revendication précédente, **caractérisé en ce que** le transistor T1 est polarisé par des résistances R12, R13 connectées entre l'alimentation et lesdites électrodes.

10. Dispositif de connexion multistandard selon l'une quelconque des revendications précédentes, **caractérisé en ce que** l'étage de polarisation du contact sec (FP5) est basé sur un transformateur TR1 dont un premier enroulement est relié à l'unité de traitement (FP8) et le second enroulement est raccordé à l'étage de connexion (FP1) via l'étage de polarisation (FP4) des voyants.

11. Dispositif de connexion multistandard selon la revendication précédente, **caractérisé en ce que** le premier enroulement du transformateur TR1 est relié à l'unité de traitement (FP8) via une diode de protection D4 et une résistance R11, le second enroulement étant raccordé à une résistance R9 connectée en série à une capacité C3, laquelle est reliée à la capacité C2 de polarisation des voyants lumineux (6).

12. Dispositif de connexion multistandard selon l'une quelconque des revendications précédentes, **caractérisé en ce que** le commutateur OP1 d'application de la polarisation des voyants lumineux (6) est basé sur un relais statique bidirectionnel à commande opto-électronique dont l'entrée est polarisée par une résistance R1 et la sortie reliée à des diodes D2, D3 de régulation de tension connectées inversées en série.

13. Procédé de détection de la nature et de l'état d'entrées d'un dispositif de connexion selon les revendications précédentes lesdites entrées étant à deux fils (2, 3), comportant un triac (5) à courant de maintien inférieur à 10 mA ou au moins un commutateur (4) et étant du type :
- issues d'un contact sec ;
- véhiculant une tension alternative comprise entre 12V et 250V ;
- véhiculant une tension continue comprise entre 12V et 250V ; ou
- véhiculant une tension alternative comprise entre 195V et 250V avec au moins un voyant lumineux (6) associé au triac ou au(x) commutateur(s) (4),
comprenant les étapes suivantes :
- détection permanente par l'unité de traitement (FP8) du niveau du
- signal en sortie de l'interface de lecture (FP7) ;
**caractérisé par** les etapes suivantes:
- si ledit niveau est à l'état bas, émission par l'unité de traitement (FP8) d'un train d'impulsions à haute fréquence à destination de l'étage de polarisation du contact sec (FP5), et
• si le signal en sortie de l'interface de lecture (FP7) reproduit ce train d'impulsion, déduction par l'unité de traitement (FP8) que le commutateur (4) est ouvert pour tout type d'entrées,
• s'il reste au niveau bas, déduction par l'unité de lecture (FP8) de la présence d'un commutateur (4) fermé pour des entrées de type contact sec ;
- si ledit niveau est à l'état haut, déduction par l'unité de lecture (FP8) de la présence d'un commutateur (4) polarisé par une tension continue, ledit commutateur (4) étant fermé ;
- si ledit niveau change d'état à une fréquence de 100 Hz, émission par l'unité de traitement (FP8) d'un signal en vue d'ouvrir le commutateur OP1 d'application de la polarisation des voyants lumineux (6), et
• si le signal en sortie de l'interface de lecture (FP7) n'est pas modifié, déduction par l'unité de traitement (FP8) qu'un commutateur (4) avec ou sans voyant (6), polarisé par une tension alternative, est fermé,
• s'il subit une discontinuité de fréquence, déduction par l'unité de traitement (FP8) que le commutateur (4) est polarisé par une tension alternative, est ouvert et doté d'un voyant (6).

## Patentansprüche

1. Multistandard-Anschlussvorrichtung, die das Erfassen der Art und des Zustands von Eingängen mit zwei Leitungen (2, 3) ermöglicht, umfassend einen Triac (5) mit Haltestrom, der niedriger als 10 mA ist, oder mindestens einen Schalter (4), wobei die Eingänge vom folgenden Typ sind:
- die aus einem potentialfreiem Kontakt hervorgegangen sind;
- die eine Wechselspannung führen, die zwischen 12 V und 250 V beträgt;
- die eine Gleichspannung führen, die zwischen 12 V und 250 V beträgt; oder
- die eine Wechselspannung führen, die zwischen 195 V und 250 V beträgt, mit mindestens einer Leuchtanzeige (6), die dem den Schalter(n) (4) oder dem Triac (5) zugeordnet ist,
wobei die Anschlussvorrichtung
aus einer elektronischen Schaltung besteht, die eine Anschlussstufe (FP1) der zwei Leitungen (2, 3) aufweist, **dadurch gekennzeichnet, dass** der Eingangsstrom nacheinander von einer Anpassungsstufe (FP3), die den Strom in einen vorbestimmten Bereich begrenzt, und von einer Lese-Schnittstelle (RP7), die ihn in ein verständliches Signal verwandelt, das an eine Verarbeitungseinheit (FP8) geschickt wird, die die Art und den Zustand des Eingangs erfasst, verarbeitet wird, wobei die Einheit (FP8) Ausgangssignale an eine Polarisationsstufe des potentialfreien Kontakts (FP5) und an einen Schalter der Anwendung der Polarisation von Leuchtanzeigen (FP6) schickt, wobei diese Stufen an eine Stufe (FP4) angeschlossen sind, die die Polarisation gewährleistet, deren Ausgang an die Anschlussstufe (FP1) angeschlossen ist, wobei Isolationsmittel zwischen der Anschlussstufe (FP1) und der Verarbeitungseinheit (FP8) vorgesehen sind.

2. Multistandard-Anschlussvorrichtung nach einem der vorhergehenden Ansprüche, **dadurch gekennzeichnet, dass** die Isolationsmittel gleichzeitig an der Lese-Schnittstelle (FP7) des Schalters der Anwendung der Polarisation von Leuchtanzeigen (FP6) und der Polarisationsstufe des potentialfreien Kontakts (FP5) eingerichtet sind.

3. Multistandard-Anschlussvorrichtung nach einem der vorhergehenden Ansprüche, **dadurch gekennzeichnet, dass** die Schaltung derart symmetrisch ist, dass die Eingänge (2, 3) depolarisiert angeschlossen werden können.

4. Multistandard-Anschlussvorrichtung nach einem der vorhergehenden Ansprüche, **dadurch gekennzeichnet, dass** eine erste Schutzstufe (FP2) gegen Stromschläge und Kurzschlussfehler sofort nachgelagert nach der Anschlussstufe (FP1) angeordnet ist.

5. Multistandard-Anschlussvorrichtung nach einem der vorhergehenden Ansprüche, **dadurch gekennzeichnet, dass** die Schutzstufe (FP2) aus einem Widerstand R2 gebildet ist, der nach einer Anschlussklemme angeordnet ist.

6. Multistandard-Anschlussvorrichtung nach einem der vorhergehenden Ansprüche, **dadurch gekennzeichnet, dass** die Anpassungsstufe (FP3), die den Bereich der Ströme begrenzt, die für die Lese-Schnittstelle (FP7) bestimmt sind, aus zwei Widerständen R5, R6 gebildet ist, die in Reihe geschaltet sind, die durch eine Kapazität C2 entkoppelt sind, die parallel zu den Widerständen R5, R6 angeschlossen ist, wobei die Kapazität C2 für mehr Polarisation der Leuchtanzeigen (6) dient.

7. Multistandard-Anschlussvorrichtung nach einem der vorhergehenden Ansprüche, **dadurch gekennzeichnet, dass** die Lese-Schnittstelle (FP7) auf einem Optokoppler IC1 basiert ist, an dessen Ausgang ein Transistor T1 angeschlossen ist, wobei der Ausgang des Transistors T1 durch eine Kapazität C11 geschützt ist, die zwischen dem Emitter und dem Kollektor angeordnet ist.

8. Multistandard-Anschlussvorrichtung nach einem der vorhergehenden Ansprüche, **dadurch gekennzeichnet, dass** der Optokoppler IC1 bidirektional ist.

9. Multistandard-Anschlussvorrichtung nach einem der vorhergehenden Ansprüche, **dadurch gekennzeichnet, dass** der Transistor T1 durch Widerstände R12, R13 polarisiert ist, die zwischen der Stromversorgung und den Elektroden angeschlossen sind.

10. Multistandard-Anschlussvorrichtung nach einem der vorhergehenden Ansprüche, **dadurch gekennzeichnet, dass** die Polarisationsstufe des potentialfreien Kontakts (FP5) auf einem Transformator TR1 basiert, dessen erste Wicklung mit der Verarbeitungseinheit (FP8) verbunden ist und dessen zweite Wicklung über die Polarisationsstufe (FP4) der Leuchtanzeigen an die Anschlussstufe (FP1) angeschlossen ist.

11. Multistandard-Anschlussvorrichtung nach einem der vorhergehenden Ansprüche, **dadurch gekennzeichnet, dass** die erste Wicklung des Transformators TR1 über eine Schutzdiode D4 und einen Widerstand R11 an die Verarbeitungseinheit (FP8) angeschlossen ist, wobei die zweite Wicklung an einen Widerstand R9 angeschlossen ist, der mit einer Kapazität C3 in Reihe geschaltet ist, die mit der Kapazität C2 der Polarisation der Leuchtanzeigen (6) verbunden ist.

12. Multistandard-Anschlussvorrichtung nach einem der vorhergehenden Ansprüche, **dadurch gekennzeichnet, dass** der Schalter OP1 der Anwendung der Polarisation der Leuchtanzeigen (6) auf einem bidirektionalen statischen Relais mit optoelektronischer Steuerung basiert ist, dessen Eingang durch einen Widerstand R1 polarisiert ist und dessen Ausgang mit Dioden D2, D3 zur Spannungsregelung verbunden ist, die umgekehrt in Reihe geschaltet sind.

13. Verfahren zum Erfassen der Art und des Zustands von Eingängen einer Anschlussvorrichtung nach einem der vorhergehenden Ansprüche, wobei die Eingänge zwei Leitungen (2, 3) aufweisen, umfassend einen Triac (5) mit Haltestrom, der niedriger als 10 mA ist, oder mindestens einen Schalter (4), und die vom folgenden Typ sind:
- die aus einem potentialfreiem Kontakt hervorgegangen sind;
- die eine Wechselspannung führen, die zwischen 12 V und 250 V beträgt;
- die eine Gleichspannung führen, die zwischen 12 V und 250 V beträgt; oder
- die eine Wechselspannung führen, die zwischen 195 V und 250 V beträgt, mit mindestens einer Leuchtanzeige (6), die dem Triac (5) oder an dem (den) Schalter(n) (4) angeschlossen ist,
umfassend die folgenden Schritte:
- permanentes Erfassen des Signalpegels am Ausgang der Lese-Schnittstelle (RP7) durch die Verarbeitungseinheit (FP8);
**gekennzeichnet durch** die folgenden Schritte:
- wenn der Pegel im Niedrigzustand ist, Abgeben von einer Hochfrequenz-Impulsserie an die Polarisationsstufe des potentialfreien Kontakts (FP5) **durch** die Verarbeitungseinheit (FP8), und
• wenn das Signal am Ausgang der Lese-Schnittstelle (FP7) diese Impulsserie wiedergibt, Ableiten **durch** die Verarbeitungseinheit (FP8), dass der Schalter (4) für jede Art von Eingängen offen ist,
• wenn er im Niedrigzustand bleibt, Ableiten **durch** die Verarbeitungseinheit (FP8) der Anwesenheit eines Schalters (4), der für Eingänge vom Typ des potentialfreien Kontakts geschlossen ist;
- wenn der Pegel im Hochzustand ist, Ableiten **durch** die Verarbeitungseinheit (FP8) der Anwesenheit eines Schalters (4), der durch eine Gleichspannung polarisiert ist, wobei der Schalter (4) geschlossen ist;
- wenn der Pegel bei einer Frequenz von 100 Hz den Zustand wechselt, Abgeben eines Signals **durch** die Verarbeitungseinheit (FP8), um den Schalter OP1 der Anwendung der Polarisation der Leuchtanzeigen (6) zu öffnen, und
• wenn das Signal am Ausgang der Lese-Schnittstelle (FP7) nicht geändert ist, Ableiten **durch** die Verarbeitungseinheit (FP8), dass ein Schalter (4) mit oder ohne Leuchtanzeige (6), der **durch** eine Wechselspannung polarisiert ist, geschlossen ist,
• wenn es eine Frequenzdiskontinuität erfährt, Ableiten **durch** die Verarbeitungseinheit (FP8), dass der Schalter (4) **durch** eine Gleichspannung polarisiert ist, offen ist und mit einer Leuchtanzeige (6) ausgestattet ist.

## Claims

1. Multistandard connection device allowing the nature and the state of two-wire inputs (2, 3) to be detected, comprising a triac (5) with a holding current of less than 10 mA or at least one control switch (4), said inputs being of the type:
- arising from a dry contact;
- conveying an AC voltage of between 12 V and 250 V;
- conveying a DC voltage of between 12 V and 250 V; or
- conveying an AC voltage of between 195 V and 250 V with at least one indicator light (6) associated with the switch(es) (4) or with the triac (5),
the connection device consisting of an electronic circuit comprising a stage (FP1) for connecting the two wires (2, 3), **characterized in that** the input current is successively processed by an adaptation stage (FP3) that limits said current to within a predetermined range and by a read interface (FP7) that transforms it into an intelligible signal sent to a processing unit (FP8) that detects the nature and the state of the input, said unit (FP8) sending output signals to a stage for biasing the dry contact (FP5) and to a switch for applying the bias to the indicator lights (FP6), these stages being connected to a stage (FP4) ensuring said biasing whose output is connected to the connection stage (FP1), isolation means being provided between the connection stage (FP1) and the processing unit (FP8).

2. Multistandard connection device according to the preceding claim, **characterized in that** the isolation means are simultaneously organized at the level of the read interface (FP7), the switch for applying the bias to the indicator lights (FP6) and the stage for biasing the dry contact (FP5).

3. Multistandard connection device according to one of the preceding claims, **characterized in that** the circuit is symmetrical, so that the inputs (2, 3) may be connected without being biased.

4. Multistandard connection device according to one of the preceding claims, **characterized in that** a first stage for protecting (FP2) against electric shocks and shorting faults is positioned immediately downstream of the connection stage (FP1).

5. Multistandard connection device according to the preceding claim, **characterized in that** the protection stage (FP2) is composed of a resistor R2 placed after a connection terminal.

6. Multistandard connection device according to any one of the preceding claims, **characterized in that** the adaptation stage (FP3) that limits the range of the currents going to the read interface (FP7) is composed of two resistors R5, R6 connected in series, decoupled by a capacitor C2 that is connected in parallel to the resistors R5, R6, said capacitor C2 additionally serving to bias the indicator lights (6).

7. Multistandard connection device according to any one of the preceding claims, **characterized in that** the read interface (FP7) is based on an optocoupler IC1 at the output of which a transistor T1 is connected, the output of the transistor T1 being protected by a capacitor C11 positioned between the emitter and collector.

8. Multistandard connection device according to any one of the preceding claims, **characterized in that** the optocoupler IC1 is bidirectional.

9. Multistandard connection device according to the preceding claim, **characterized in that** the transistor T1 is biased by resistors R12, R13 that are connected between the power supply and said electrodes.

10. Multistandard connection device according to any one of the preceding claims, **characterized in that** the stage for biasing the dry contact (FP5) is based on a transformer TR1 whose first winding is connected to the processing unit (FP8) and whose second winding is connected to the connection stage (FP1) via the stage for biasing (FP4) the indicators.

11. Multistandard connection device according to the preceding claim, **characterized in that** the first winding of the transformer TR1 is connected to the processing unit (FP8) via a protection diode D4 and a resistor R11, the second winding being connected to a resistor R9 that is connected in series with a capacitor C3, which is connected to the capacitor C2 for biasing the indicator lights (6).

12. Multistandard connection device according to any one of the preceding claims, **characterized in that** the switch OP1 for applying the bias to the indicator lights (6) is based on an optoelectronically controlled bidirectional static relay whose input is biased by a resistor R1 and whose output is connected to voltage-regulating diodes D2, D3 that are reverse-connected in series.

13. Method for detecting the nature and the state of inputs of a connection device according to the preceding claims, said inputs being two-wire inputs (2, 3), comprising a triac (5) with a holding current of less than 10 mA or at least one switch (4) and being of the type:
- arising from a dry contact;
- conveying an AC voltage of between 12 V and 250 V;
- conveying a DC voltage of between 12 V and 250 V; or
- conveying an AC voltage of between 195 V and 250 V with at least one indicator light (6) associated with the triac or with the switch(es) (4),
comprising the following steps:
- continuous detection, by the processing unit (FP8), of the level of the signal output by the read interface (FP7),
**characterized by** the following steps:
- if said level is in the low state, a highfrequency pulse train is transmitted by the processing unit (FP8) to the stage for biasing the dry contact (FP5), and
• if the signal output by the read interface (FP7) reproduces this pulse train, the processing unit (FP8) deduces that the switch (4) is open to any type of input;
• if it remains in the low state, the read unit (FP8) deduces the presence of a switch (4) that is closed to inputs of dry contact type;
- if said level is in the high state, the read unit (FP8) deduces the presence of a switch (4) that is biased by a DC voltage, said switch (4) being closed;
- if said level changes state at a frequency of 100 Hz, the processing unit (FP8) transmits a signal in order to open the switch OP1 that applies the bias to the indicator lights (6), and
• if the signal output by the read interface (FP7) is not altered, the processing unit (FP8) deduces that a switch (4) with or without indicator (6), biased by an AC voltage, is closed;
• if it is subject to a frequency discontinuity, the processing unit (FP8) deduces that the switch (4) is biased by an AC voltage, is open and equipped with an indicator (6).
